(19) Europäisches Patentamt
European Patent Office
Office européen des brevets

(11) EP 2 071 626 A1

(12) EUROPEAN PATENT APPLICATION

(43) Date of publication:
17.06.2009 Bulletin 2009/25

(51) Int Cl.:
H01L 25/07 (2006.01)     H01L 25/18 (2006.01)

(21) Application number: 07122814.2

(22) Date of filing: 11.12.2007

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(71) Applicant: ABB Research Ltd.
8050 Zürich (CH)

(72) Inventors:
• Skibin, Stanislav
5415 Nussbaumen (CH)
• Cottet, Didier
5405 Baden-Dättwil (CH)

(74) Representative: ABB Patent Attorneys
c/o ABB Schweiz AG,
Intellectual Property (CH-LC/IP),
Brown Boveri Strasse 6
5400 Baden (CH)

(54) **Semiconductor module and connection terminal device**

(57)     A semiconductor module is provided which comprises a base substrate (100) including a semiconductor devices, an emitter terminal unit (200) adapted to electrically connect an emitter of the semiconductor circuit to an external circuit unit and a collector terminal unit (300) adapted to electrically connect a collector of the semiconductor circuit to the external circuit unit. The emitter terminal unit (200) and the collector terminal unit (300) each have resilient elements (204, 205, 304, 305) which are arranged in parallel to the substrate (100).

FIG. 7

EP 2 071 626 A1

## Description

## BACKGROUND

The present invention relates to power semiconductor devices, and in particular it relates to a semiconductor module having an electrical connection device for connecting the semiconductor module to external circuit units.

Specifically, the present invention relates to semiconductor modules with Insulated Gate Bipolar Transistors (IGBTs) wherein a base substrate including semiconductor devices (IGBTs and diodes), an emitter terminal unit adapted to electrically connect an emitter of the semiconductor circuit to an external circuit unit and a collector terminal unit adapted to electrically connect a collector of the semiconductor circuit to the external circuit unit is provided.

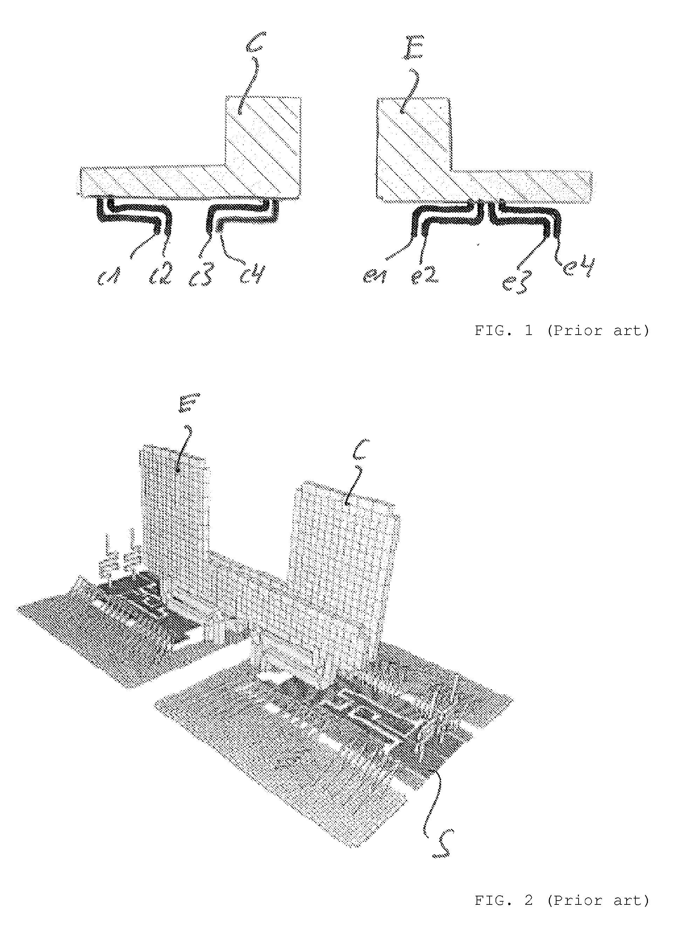

Figs. 1 and 2 exhibit the principal design of collector and emitter terminal units C and E, respectively, and their respective connection to a semiconductor base plate of a power semiconductor module. As shown in Fig. 1, the collector terminal unit C and the emitter terminal unit E each have contacting means, i.e. contacting means c1, c2, c3 and c4 for the collector terminal unit C and contacting means e1, e2, e3 and e4 for the emitter terminal unit E.

As shown in Fig. 2, the emitter terminal unit E and the collector terminal unit C are installed in an upright position, i.e. vertical to a plane which constitutes the semiconductor device S. The emitter terminal unit E and the collector terminal unit C are designed in a nearly two-dimensional shape (see Fig. 1) such that all terminal elements at the terminal body and spring legs, i.e. the collector contacting means c1, c2, c3 and c4 and the emitter contacting means e1, e2, e3 and e4, are arranged in the same plane. An advantage of such a two-dimensional arrangement of all terminal elements is the possibility of an easy manufacturing and an easy placement for a soldering process. Furthermore, the collector terminal unit C and the emitter terminal unit E according to the state of the art have relatively low electrical resistance, i.e. approximately 60 m$\Omega$ per terminal unit. Furthermore, it is appropriate that this design of a two-dimensional arrangement exhibits short electrical connection sections from the external collector/emitter contacts of the module to the substrates using a massive terminal body.

A major disadvantage of the conventional terminal design as shown in Fig. 1 and 2 is that terminal legs need to be thin in order to provide sufficient mechanical flexibility. This is a major disadvantage because the electrical resistance is increased resulting in a self-heating of the respective terminal unit. As shown especially in Fig. 2, the terminal units E and C are arranged in an unsymmetrical manner with respect to the substrate S. This results in the disadvantage of the terminal design according to prior art that significant turn-on/turn-off electromagnetic interference problems occur inside the module, the electromagnetic interference being based mainly on the dynamic current imbalance.

Another drawback of the conventional terminal design is that it provides mechanical flexibility only in one plane. Thus, a spring constant of about 120 N/mm is provided which is rather high, even if thin terminal legs are used.

## SUMMARY

It is thus an object of the present invention to provide an electrical connection device for a semiconductor device carrying at least one substrate which is capable of carrying high currents, which can withstand high temperatures and which provides a secure and mechanically stable contacting of the semiconductor devices carrying substrates to an external circuit unit without electromagnetic interference problems.

The above object is solved by an electrical connection device for a semiconductor device carrying a substrate according to the independent patent claim 1. Furthermore, the above object is solved by a semiconductor module comprising the features of independent claim 14.

Further preferred developments of the present invention are according to the dependent claims.

According to a first aspect of the present invention an electrical connection device for at least one semiconductor device carrying at least one substrate is provided, the electrical connection device comprising an emitter terminal unit adapted to electrically connect an emitter of the at least one semiconductor device carrying at least one substrate to an external circuit unit, and a collector terminal unit adapted to electrically connect a collector of the at least one semiconductor device carrying at least one substrate to the external circuit unit, wherein the emitter terminal unit and the collector terminal unit are arranged in separate planes which are parallel to each other, and wherein the emitter terminal unit and the collector terminal unit each exhibit a symmetry, in their respective planes, with respect to an axis which is perpendicular to the planes.

According to a second aspect of the present invention a semiconductor module is provided, comprising a base substrate including a semiconductor devices carrying substrates, an emitter terminal unit adapted to electrically connect an emitter of the semiconductor devices carrying substrates to an external circuit unit, and a collector terminal unit adapted to electrically connect a collector of the semiconductor devices carrying substrates to the external circuit unit, wherein the emitter terminal unit and the collector terminal unit each have resilient elements which are arranged in parallel to the base substrate.

## DRAWINGS

Embodiments of the present invention are depicted in the drawings and are detailed in the description which follows.

In the drawings:

Fig. 1 is a side view of a conventional terminal unit for connecting a collector and an emitter of a semiconductor circuit to external circuit units;

Fig. 2 is an elevation view wherein the emitter and collector terminal units are arranged on a substrate and wherein the emitter and collector terminal units are arranged in an upright position;

Fig. 3 is a perspective view of a collector terminal unit according to a preferred embodiment of the present invention;

Fig. 4 shows the collector terminal unit depicted in Fig. 3 in a plain view before applying a bending process;

Fig. 5 is a perspective view, seen from a similar direction as the view shown in Fig. 3, of an emitter terminal unit according to a preferred embodiment of the present invention;

Fig. 6 is a plane view of the emitter terminal unit depicted in Fig. 5 before a bending process has been carried out;

Fig. 7 is a schematic elevation view of a semiconductor module having a collector terminal unit and an emitter terminal unit arranged in parallel above a base substrate according to a preferred embodiment of the present invention;

Fig. 8 is a schematic view which illustrates the combination of two stiff elements and a flexible element in order to provide a string-like structure for evaluating a spring constant of the collector terminal unit and/or the emitter terminal unit;

Fig. 9 is a cross-sectional view of a spring element in order to evaluate a spring constant;

Fig. 10 is a cross-sectional view of the spring element shown in Fig. 9 wherein a displacement has been applied;

Fig. 11(a) are two graphs showing currents flowing in a conventional terminal unit;

Fig. 11(b) exhibits currents flowing in the terminal units according to the preferred embodiment of the present invention; and

Fig. 12 is a table showing design parameters of an electrical connection device having the terminal units according to the preferred embodiment of the present invention.

In the Figures, same reference numerals denote the same or similar parts or steps.

**DESCRIPTION**

The idea of the present invention is to provide an electrical connection device for a semiconductor circuit which has a symmetry in a plane which is parallel to a semiconductor base substrate.

According to the present invention, an emitter terminal unit adapted to electrically connect an emitter of the semiconductor circuit to an external circuit unit and a collector terminal unit adapted to electrically connect a collector of the semiconductor circuit to the external circuit unit are arranged such that the emitter terminal unit and the collector terminal unit are in parallel to each other.

The major advantage of the present invention is that a mechanical stability together with low electromagnetic interference can be provided. An important issue in power semiconductor module development is an increase in the operation junction temperature of the semiconductor which implicitly means an increase in operation currents. Under these circumstances, the collector and emitter terminal units are critical components of the entire power semiconductor module design. This is because on the one hand there is the self-heating of the respective terminal unit due to resistive power losses, and on the other hand there is mechanical stress caused by thermal extension of the respective terminal unit.

Furthermore, electromagnetic interferences (EMI) inside the power semiconductor module are a major issue. Dynamic imbalance in power semiconductor modules is a cause for electromagnetic interferences, especially during turn-on and turn-off periods.

It is expedient that the terminal unit design according to the present invention is adaptable to medium voltage (MV) power modules, also called HiPak-modules, which is a family of high-power Insulated Gate Bipolar Transistors(IGBTs) in industry-standard housings. MV power modulesexclusively use aluminum silicon carbide (AlSiC) base plate material for a good thermal cycling capability and aluminum nitride (AIN) isolation for low thermal resistance. The medium voltage power semiconductor modules have been optimized for reliable operation even in harsh environments.

According to the present invention, a terminal unit design is provided which has a high mechanical flexibility together with low electrical resistance. Furthermore, an imbalance in current distribution is avoided. The terminal unit design according to the present invention takes into account each of the above-mentioned issues. Thus, the terminal unit design according to the present invention includes a concept design of both collector and emitter terminals and their placement in an existing MV power semiconductor module.

It is thus another advantage of the present invention that longer lifetime and improved and reliable mechanical and electrical characteristics of the entire power semiconductor module can be provided. Furthermore, an excellent elastic flexibility in all planes as well as an outstanding dynamic current distribution across the power semiconductor module is achieved.

According to a first embodiment of the present invention, an electrical connection device for a semiconductor devices carrying substrates is provided, wherein the electric connection device comprises an emitter terminal unit adapted to electrically connect an emitter of the semiconductor devices carrying substrates to an external circuit unit and a collector terminal unit adapted to electrically connect a collector of the semiconductor devices carrying substrates to the electrical circuit unit. Preferably, the semiconductor part of a power module comprises IGBTs and diodes. The emitter terminal unit and the collector terminal unit are arranged in parallel to each other.

According to a second embodiment of the present invention, a semiconductor module is provided which comprises a base substrate including a semiconductor circuit, an emitter terminal unit adapted to electrically connect an emitter of the semiconductor circuit to an external circuit unit and a collector terminal unit adapted to electrically connect a collector of the semiconductor circuit to the external circuit unit. Thus, preferably the semiconductor module comprises an IGBT within a housing. The emitter terminal unit and the collector terminal unit preferably each have resilient elements which are arranged in parallel to the base substrate.

According to a preferred development of the present invention, the emitter terminal unit and the collector terminal unit each comprise connection elements for connecting the respective terminal unit to the external circuit unit. It is an advantage if the respective connection elements, i.e. a collector connection element and an emitter connection element, are arranged near a central axis of the power semiconductor module, i.e. an axis which is perpendicular to the plane of a base plate.

Preferably, the emitter terminal unit is arranged between the collector terminal unit and the base substrate wherein the emitter terminal unit, the collector terminal unit and the base substrate are arranged in planes which are in parallel to each other.

According to yet another preferred development of the present invention, the connection elements are arranged in parallel to an axis which is perpendicular to the base substrate.

According to yet another preferred development of the present invention, the emitter terminal unit and the collector terminal unit each comprise first and second contacting studs for contacting the respective terminal unit to the base substrate. Preferably, the emitter terminal unit has first and second emitter contacting studs, wherein the collector terminal unit has first and second collector contacting studs.

According to yet another preferred development of the present invention, the emitter terminal unit comprises first and second emitter resilient elements for connecting the first and second emitter contacting studs for the emitter connection element.

In addition to that, preferably the collector terminal unit comprises first and second collector resilient elements for connecting the first and second collector contacting studs to the collector connection element.

It is an advantage that the first and second resilient elements of the emitter terminal unit and the collector terminal unit are extended in a plane which is parallel to the base substrate. Furthermore, the first and second resilient elements are formed in an O-shaped structure.

Furthermore, it is advantageous to form the emitter terminal unit and the collector terminal unit in a structure which is axially symmetric with respect to an axis which is perpendicular to the base substrate.

According to yet another preferred development of the present invention, the first and second resilient elements of the emitter terminal unit and the collector terminal unit have merely identical cross-sectional shapes.

According to yet another preferred development of the present invention, the first and second resilient elements of the emitter terminal unit and the collector terminal unit are shaped in a double-O-structure with respect to a plane which is parallel to the base substrate.

It is preferred that the emitter terminal unit and the collector terminal unit each have stiff elements forming the contacting studs. Furthermore, it is preferred that the emitter terminal unit and the collector terminal unit each have stiff elements forming the respective connection elements. Advantageously, the emitter terminal unit and the collector terminal unit each have flexible elements forming the resilient elements between the respective stiff elements forming the contacting studs and the respective stiff elements forming the respective connection elements.

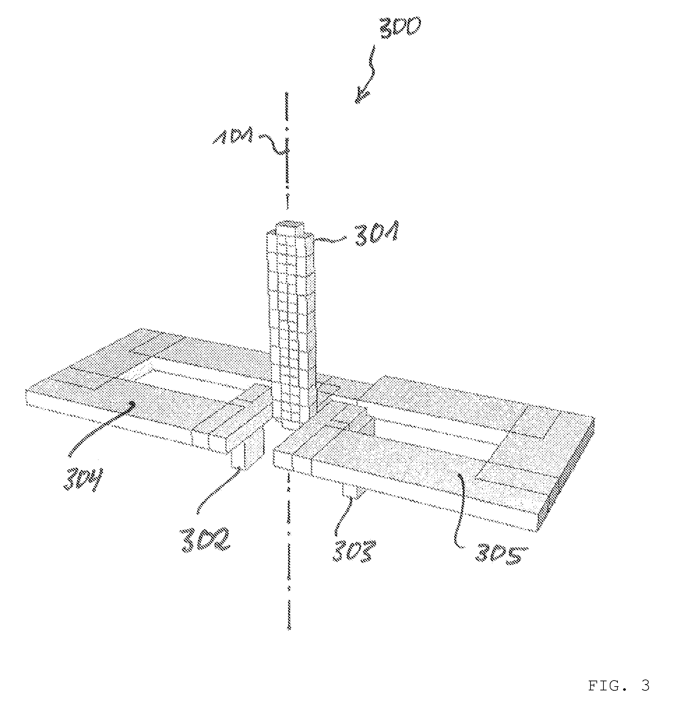

Herein below, a preferred embodiment of the present invention is described with respect to Figs. 3 to 12.

Fig. 3 is a perspective view of a collector terminal unit 300 according to a preferred embodiment of the present invention. As shown, the collector terminal unit 300 comprises a collector connection element 301 which is parallel to an axis 101 which is a base substrate normal axis (see below).

As shown in Fig. 3, the rest of the collector terminal unit 300 is extended in a plane the normal vector of which is parallel to the base substrate normal axis 101. The main sections of the collector terminal unit 300 consist of two collector resilient elements, i.e. a first collector resilient element 304 and a second collector resilient element 305. The resilient elements 304, 305 are formed in order to provide a mechanical and an electrical connection between the collector connection element 301 and first and second collector contacting studs 302 and 303, respectively. The first and second collector contacting studs 302 and 303 extend downwards from the plane which is defined by the first and second collector resilient elements 304, 305. The first and second collector contacting studs 302, 303 thus extend in a direction which is parallel to the base substrate normal axis 101.

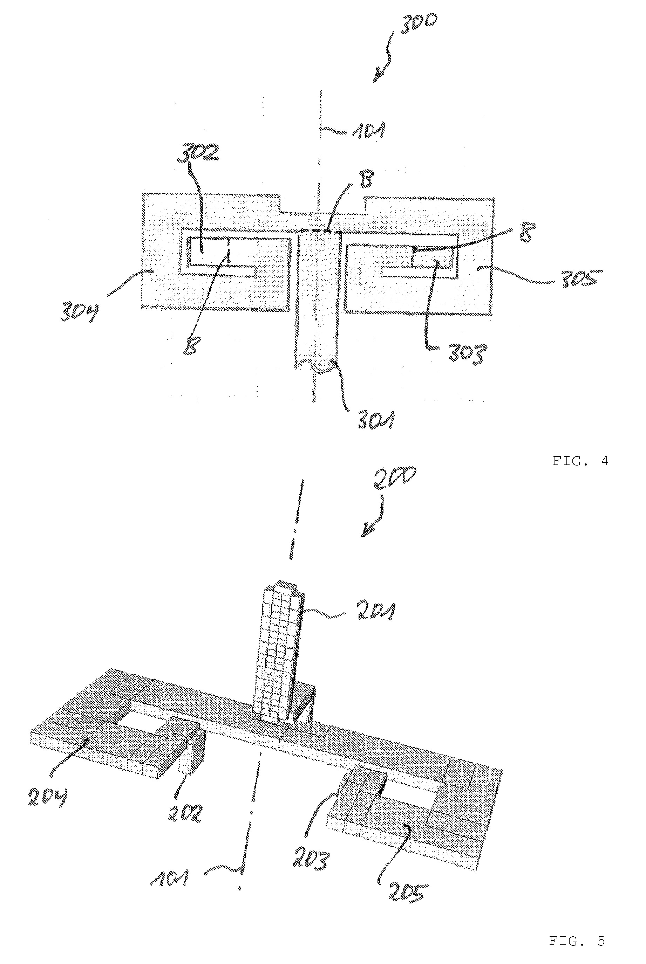

Fig. 4 illustrates a plane view of the collector terminal unit 300 before bending along bending lines (dashed lines in the Figure B) is applied. As can be seen from Fig. 4, the manufacturing of the collector terminal unit 300 according to a preferred embodiment of the present invention is easily achieved by punching a structure shown in Fig. 4 and by bending along the bending lines B shown in Fig. 4. Such bending is performed downwards in order to obtain the first and second collector resilient elements 304 and 305 and such bending is performed upwards in order to provide a collector collection element 301. After these bending processes, the collector terminal unit as shown in the perspective view of Fig. 3 is obtained.

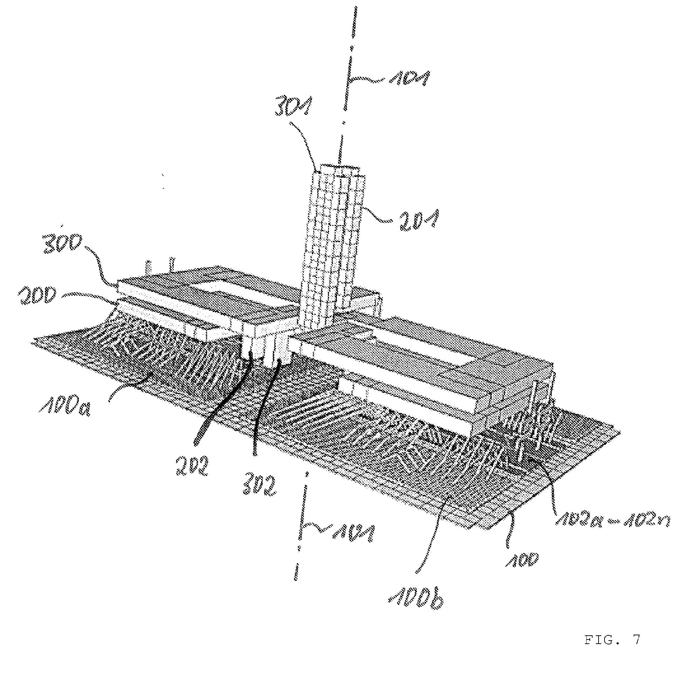

Fig. 5 shows a perspective view of an emitter terminal unit 200 according to a preferred embodiment of the present invention. It is noted that the observation angle of Figs. 3 and 4 is identical such that it can be seen that it is possible to arrange the emitter terminal unit 200 in a plane below the collector terminal unit 300 (see also Fig. 7 below).

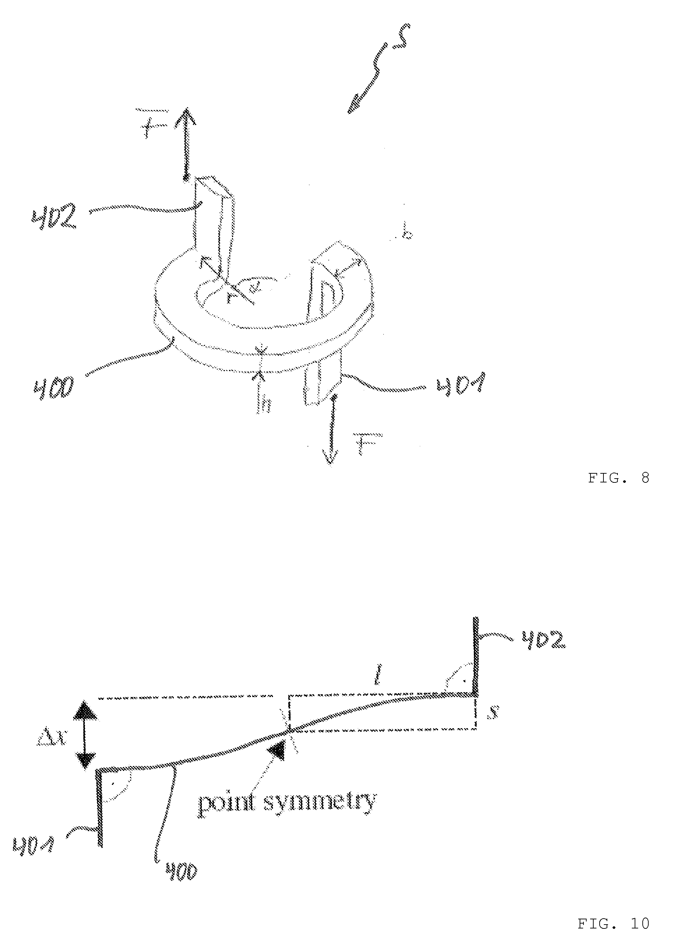

The structure of the emitter terminal unit 200 is similar to that of the collector terminal unit 300 shown in Fig. 3. The emitter terminal unit 200 acts essentially as an emitter connection element 201 which is arranged perpendicular to an axis which is normal to a base substrate, i.e. a base substrate normal axis 101. As the collector terminal unit 300 (Fig. 3), the emitter terminal 200 has first and second emitter resilient elements 204 and 205, respectively, which are arranged in a plane, the normal vector of which is parallel to the base substrate normal axis 101. Furthermore, the emitter terminal unit 200 has first and second emitter contacting studs 202 and 203, respectively, for contacting an emitter of the semiconductor devices carrying substrates. The first emitter contacting stud 202 is connected to the emitter connection element 201 via the first emitter resilient element 204, wherein the second emitter contacting stud 203 is connected to the emitter connection element 201 via the second emitter resilient element 205. Thus, the first and second emitter resilient elements 204 and 205, respectively, provide a mechanical and an electrical connection. The mechanical properties of the collector and emitter resilient elements are described in detail herein below with reference to Figs. 8 to 10.

As shown in Fig. 3 and 5, the collector terminal unit 300 and the emitter terminal unit 200 each comprise terminal bodies such as to obtain two horizontal, axially symmetric O-shaped sections each. It is essential that the whole surface of the O-shaped section of the terminal is used to provide an excellent mechanical flexibility in all planes, even when using thick materials for the collector terminal unit and the emitter terminal unit. The manufacturing of the collector terminal unit 300 and the emitter terminal unit 200 may be provided by water jet cutting or by pressing methods from a single sheet of copper.

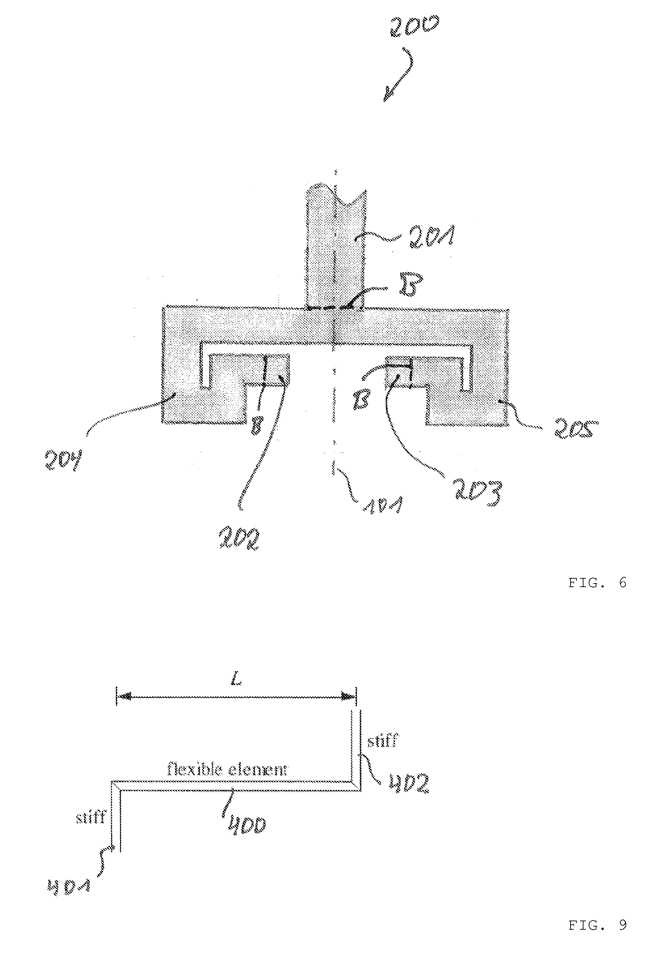

Furthermore, Fig. 6 exhibits a plane view of the emitter terminal unit 200. As before and as described with respect to Fig. 4, the graph of Fig. 6 shows a terminal unit before bending. For the emitter terminal unit 200, the bending lines are depicted by a reference numeral B and by dashed lines. Thus, the sections representing the first emitter contacting stud 202 and the second emitter contacting stud 203 are bent downwards, whereas the section representing the emitter connection element 201 is bent upwards such that the structure shown in Fig. 5 is obtained.

Fig. 7 is a schematic perspective view of a power semiconductor module having a base substrate 100 which is extended in a plane perpendicular to the base substrate normal axis 101. Furthermore, the power semiconductor module shown in Fig. 7 comprises the terminal unit described above, i.e. the emitter terminal unit 200 and the collector terminal unit 300. As shown, the emitter terminal unit 200 and the collector terminal unit 300 are arranged in parallel to each other and in parallel to the base substrate 100. Furthermore, electronic components 102a-102n are shown mounted on the base substrate 100.

As it is shown in Fig. 7, the O-shaped structures of both the collector terminal unit 300 and the emitter terminal unit 200 nearly coincide with each other or are the same such that electromagnetic interference effects can be minimized. Furthermore, both the collector terminal unit 300 and the emitter terminal unit 200 provide sufficient mechanical flexibility for connecting the collector and emitter of the base substrate 100 via the first and second collector contacting studs 302, 303 and the first and second emitter contacting studs 202, 203, respectively.

The connection elements, i.e. the emitter connection element 201 and the collector connection element 301, are arranged parallel to each other and parallel to the base substrate normal axis 101 such that an electrical connection to external circuit units may be provided. It is noted that the power semiconductor module shown in Fig. 7 is adapted to MV power modules mentioned above.

In the following, mechanical properties of the emitter terminal unit 200 and the collector terminal unit 300 shown above will be described with respect to Figs. 8 to 10. Fig. 8 is a schematic view of a spring element S in order to calculate spring constants. As shown in Fig. 8, two stiff elements, i.e. a first stiff element 401 and a second stiff element 402, are forced in opposite directions by a force F. The first stiff element 401 is connected to the second stiff element 402 of the flexible element 400 having a thickness of h, a width of b and a radius of r (see Fig. 8). With respect to Fig. 8, the spring constant of the terminal unit shown above may be estimated. It is noted that Fig. 8 is a simplified version of first and second emitter resilient elements and first and second collector resilient elements, respectively. For calculating the spring constant, the winding (three quarters) shown in Fig. 8 is unrolled which results in a shape shown in Fig. 9. Here, L defines the length of the flexible element 400, wherein the stiff elements 401 and 402 are attached to the ends of the flexible element 400. Thus, the unrolled version of the terminal consists of a flexible element of the length L, wherein both ends of the terminal are supposed to be stiff. The length L, using Figs. 8 and 9, is expressed as:

$$L = 2r\pi\frac{\alpha}{360°}$$

The midpoint of the flexible element 400 is a symmetry point such that only one half of this element has to be modelled as a lever. This situation is shown in Fig. 10 wherein the arrow indicates the point symmetry. Thus, the length of the lever is

$$l = \frac{L}{2}$$

A shift s of the lever tip can be expressed as

$$s = \frac{\Delta x}{2}$$

wherein $\Delta x$ is the differnce in length by application of a force F.
According to "Stöker, Taschenbuch der Physik, page 152, Verlag Harri Deutsch", the shift s may be expressed according to the following equation:

$$s = \frac{l^3}{3} \cdot \frac{F}{E \cdot J_a}$$

wherein E is the elastic modulus and $J_a$ is the axial angular impulse which is for a rectangular cross-section:

$$J_a = \frac{b \cdot h^3}{12}$$

wherein b is the width and h is the thickness of the flexible element 400.
The above equations can be solved in order to obtain the spring constant from the following equation:

$$k = \frac{F}{\Delta x} = E \cdot b \cdot \left(\frac{h}{L}\right)^3$$

In order to calculate a spring constant, as an example values are inserted such as E = 128 GPa, L = 70 mm, b = 6 mm, h = 2,5 mm (see Fig. 8). The spring constant becomes:

$$\Rightarrow k \cong 34932 \frac{N}{m} = 34.9 \frac{N}{mm}$$

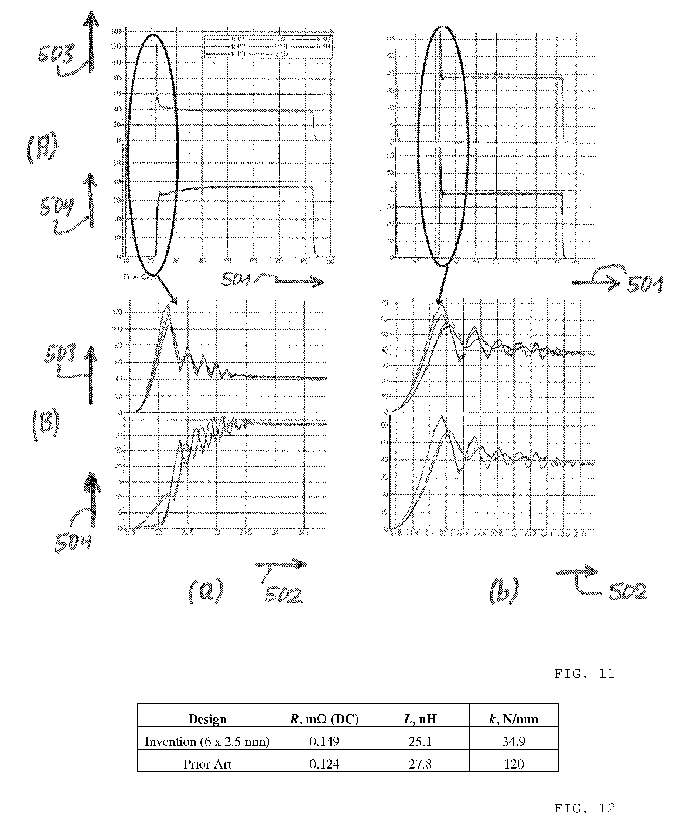

Fig. 11 shows four separate graphs exhibiting current distributions as a function of time. The graphs have different time scales such as a time scale 501 where time is measured in $\mu$s the division being 10 $\mu$s/div (10 microseconds/division). The time scale of the two diagrams shown below in Fig. 11 is in $\mu$s, wherein the scale is 200 ns/div (200 nanoseconds/division).
Thus, the upper row of diagrams (A) shows current distributions on a reduced time scale wherein the lower row of diagrams (B) shows current distributions on an enlarged time scale. Fig. 11(a) are current distributions in conventional terminal units, whereas Fig. 11(b) shows, as a comparison, current distributions of the terminal units according to a preferred embodiment of the present invention. In each of the four diagrams two currents are shown, i.e. a first collector down current 503 and a collector up current 504. Herein the term collector down current 503 denotes a current which is flowing via a first collector contacting stud, i.e. to a first portion 100a of the base substrate 100, whereas the term collector up current means that the current is flowing via a second collector contacting stud, i.e. to a second portion 100b of the base substrate 100 (see Fig. 7).
As shown in Fig. 11(a), the conventional electrical connection device exhibits a large asymmetry of the up and down currents resulting in large electromagnetic interferences (EMI). In contrast to that, as shown in Fig. 11(b), the collector terminal unit 300 and the emitter terminal unit 200 arranged according to a preferred embodiment of the present invention (Fig. 7) nearly have symmetrical distributions of the collector down current and the collector up current.
Furthermore, the analysis of Fig. 11(b) compared to Fig. 11(a) exhibits a significant improvement of the turn-on transient characteristics. The turn-on current peak of the lower substrate IGBTs has been reduced from around 130 A to around 70 A. In addition to that, the asymmetric turn-on current distribution of the electrical connection device according to the state of the art is almost completely balanced when using the terminal unit design according to the present invention (Fig. 11(b)).

Fig. 12 is a table showing design parameters with respect to terminal resistance and inductance and a corresponding spring constant of electrical connection devices according to prior art (last line in the table of Fig. 12) compared to the design of the terminal unit according to the present invention (second line of the table shown in Fig. 12). The comparison has been made under the assumption that the terminal units according to the present invention are made of copper wherein the flexible element has a cross-section of 6 mm x 2.5 mm. It is shown that the terminal resistances according to the present invention are only slightly increased with respect to the prior art design, whereas the inductances are slightly decreased. A major advantage of the present invention may be seen from the last column of the table shown in Fig. 12. It is evident that the spring constant k of the terminal unit according to the present invention is much smaller than the spring constant of a terminal unit of an electrical connection device according to prior art (reduction from 120 N/mm to 34.9 N/mm).

Thus, the terminal unit according to the preferred embodiment of the present invention provides improved mechanical and electrical characteristics and has reduced electromagnetic interferences. The very high mechanical flexibility of the terminal units according to the present invention allows a large variation of the materials' width and thickness parameters for different applications without worsening electromagnetic and mechanical properties. The symmetrical placement of the emitter and collector pair on the substrates provides an outstanding dynamic current distribution across the whole module. The electrical resistance is only slightly increased.

A major advantage of the terminal unit design according to the present invention is that it is applicable to MV power modules. Furthermore, the design concept according to the present invention can be used in any kind of power semiconductor modules in which high electric and electromagnetic reliability have to coexist with excellent mechanical characteristics of the terminal units. The terminal unit design concept according to the present invention allows symmetrical terminal placement of the substrates horizontally as well as vertically. The symmetrical placement of the emitter and collector pair provides outstanding dynamic current distribution across the module.

It will be obvious to those skilled in the art, based upon the teachings herein, that changes and modifications may be made without departing from the invention disclosed and its broader aspects. That is, all examples set forth herein above are intended to be exemplary and non-limiting.

## LIST OF REFERENCE NUMERALS

| | |
|---|---|
| 100 | Base substrate |
| 101 | Base substrate normal axis |
| 200 | Emitter terminal unit |
| 201 | Emitter connection element |
| 202 | First emitter contacting stud |
| 203 | Second emitter contacting stud |
| 204 | First emitter resilient element |
| 205 | Second emitter resilient element |
| 300 | Collector terminal unit |
| 301 | Collector connection element |
| 302 | First collector contacting stud |
| 303 | Second collector contacting stud |
| 304 | First collector resilient element |
| 305 | Second collector resilient element |
| 400 | Flexible element |
| 401 | First stiff element |
| 402 | Second stiff element |
| 501 | Time in $\mu$s (10 $\mu$s/div) |
| 502 | Time in $\mu$s (200 ns/div) |
| 503 | Collector down current |
| 504 | Collector up current |

## Claims

1. An electrical connection device for a semiconductor devices carrying substrates, the electrical connection device comprising:

   a) an emitter terminal unit (200) adapted to electrically connect an emitter of the at least one semiconductor device carrying at least one substrates to an external circuit unit; and
   b) a collector terminal unit (300) adapted to electrically connect a collector of the at least one semiconductor device carrying at least one substrate to the external circuit unit, wherein
   c) the emitter terminal unit (200) and the collector terminal unit (300) are arranged in separate planes which are parallel to each other, and wherein the emitter terminal unit (200) and the collector terminal unit (300) each exhibit a symmetry, in their respective planes, with respect to an axis which is perpendicular to the planes.

2. The electrical connection device according to claim 1, wherein the emitter terminal unit (200) and the collector terminal unit (300) each comprise connection elements (201, 301) for connecting the respective terminal unit to the external circuit unit.

3. The electrical connection device according to claim 1, wherein the semiconductor devices on the carrying substrates are IGBTs and diodes.

**4.** The electrical connection device according to claim 1, wherein the emitter terminal unit (200) and the collector terminal unit (300) each comprise first and second contacting studs 202, 203, 302, 303).

**5.** The electrical connection device according to claim 4, wherein the emitter terminal unit (200) comprises first and second emitter resilient elements (204, 205) for connecting the first and second emitter contacting studs (202, 203) to the emitter connection element (201).

**6.** The electrical connection device according to claim 4, wherein the collector terminal unit (300) comprises first and second collector resilient elements (304, 305) for connecting the first and second collector contacting studs (302, 303) to the collector connection element (301).

**7.** The electrical connection device according to claim 5 and 6,
wherein the first and second resilient elements (204, 205, 304, 305) of the emitter terminal unit (200) and the collector terminal unit (300) are extended in planes which are parallel to each other.

**8.** The electrical connection device according to claim 1, wherein the emitter terminal unit (200) and the collector terminal unit (30) are formed in a structure which is symmetric in a plane of the respective terminal unit.

**9.** The electrical connection device according to claim 7, wherein the first and second resilient elements (204, 205, 304, 305) of the emitter terminal unit (200) and the collector terminal unit (300) have nearly identical cross-sectional shapes, in particular have the identical cross-sectional shapes.

**10.** The electrical connection device according to claim 9, wherein the first and second resilient elements (204, 205, 304, 305) of the emitter terminal unit (200) and the collector terminal unit (300) are each shaped in a double-O-structure with respect to planes which are parallel to each other.

**11.** The electrical connection device according to claim 4, wherein the emitter terminal unit (200) and the collector terminal unit (300) each have stiff elements forming the contacting studs (202, 203, 302, 303).

**12.** The electrical connection device according to claim 1, wherein the emitter terminal unit (200) and the collector terminal unit (300) each have stiff elements forming the respective connection elements (201, 301).

**13.** The electrical connection device according to claim 5 and 6,
wherein the emitter terminal unit (200) and the collector terminal unit (300) each have flexible elements forming the resilient elements (204, 205, 304, 305).

**14.** A semiconductor module, comprising:

a) a base substrate (100) including a semiconductor devices;
b) an emitter terminal unit (200) adapted to electrically connect an emitter of the semiconductor devices carrying substrates to an external circuit unit; and
c) a collector terminal unit (300) adapted to electrically connect a collector of the semiconductor devices carrying substrates to the external circuit unit, wherein
d) the emitter terminal unit (200) and the collector terminal unit (300) each have resilient elements (204, 205, 304, 305) which are arranged in parallel to the base substrate (100).

**15.** The semiconductor module according to claim 14, wherein the emitter terminal unit (200) is arranged between the collector terminal unit (300) and the base substrate (100).

**16.** The semiconductor module according to claim 14, wherein the emitter terminal unit (200) and the collector terminal unit (300) each comprise connection elements (201, 202) for connecting the respective terminal unit (200, 300) to the external circuit unit.

**17.** The semiconductor module according to claim 16, wherein the connection elements (201, 301) are arranged in parallel to an axis which is perpendicular to the base substrate (100).

**18.** The semiconductor module according to claim 14, wherein the emitter terminal unit (200) and the collector terminal unit (300) each comprise first and second contacting studs (202, 203, 302, 303) for contacting the respective terminal unit (200, 300) to the base substrate (100).

**19.** The semiconductor module according to claim 18, wherein the emitter terminal unit (200) comprises first and second emitter resilient elements (204, 205) for connecting the first and second emitter contacting studs (202, 203) to the emitter connection element (201).

**20.** The semiconductor module according to claim 18, wherein the collector terminal unit (300) comprises first and second collector resilient elements (304, 305) for connecting the first and second collector contacting studs 302, 303) to the collector connection element (301).

**21.** The semiconductor module according to claim 19 and 20, wherein the first and second resilient elements (204, 205, 304, 305) of the emitter terminal unit (200) and the collector terminal unit (300) are extended in a plane which is parallel to the base substrate (100) and are formed in an O-shaped structure.

**22.** The semiconductor module according to claim 14, wherein the emitter terminal unit (200) and the collector terminal unit (300) are formed in a structure which is axially symmetric with respect to an axis which is perpendicular to the base substrate (100).

**23.** The semiconductor module according to claim 19 and 20, wherein the first and second resilient elements (204, 205, 304, 305) of the emitter terminal unit (200) and the collector terminal unit (300) have nearly identical cross-sectional shapes, in particular have the identical cross-sectional shapes.

**24.** The semiconductor module according to claim 19 and 20, wherein the first and second resilient elements (204, 205, 304, 305) of the emitter terminal unit (200) and the collector terminal unit (300) are shaped in a double-O-structure with respect to a plane which is parallel to the base substrate (100).

**25.** The semiconductor module according to claim 18, wherein the emitter terminal unit (200) and the collector terminal unit (300) each have stiff elements forming the contacting studs (202, 203, 302, 303).

**26.** The semiconductor module according to claim 16, wherein the emitter terminal unit (200) and the collector terminal unit (300) each have stiff elements forming the respective connection elements (201, 301).

**27.** The semiconductor module according to claim 19 and 20, wherein the emitter terminal unit (200) and the collector terminal unit (300) each have flexible elements (400) forming the resilient elements (204, 2055, 304, 305).

FIG. 1 (Prior art)

FIG. 2 (Prior art)

FIG. 3

FIG. 4

FIG. 5

200

201

B

204

202

101

203

205

FIG. 6

L

stiff

flexible element

402

stiff

400

401

FIG. 9

FIG. 7

FIG. 8

FIG. 10

FIG. 11

| Design | R, mΩ (DC) | L, nH | k, N/mm |
|---|---|---|---|
| Invention (6 x 2.5 mm) | 0.149 | 25.1 | 34.9 |
| Prior Art | 0.124 | 27.8 | 120 |

FIG. 12

**European Patent Office**

**EUROPEAN SEARCH REPORT**

Application Number

EP 07 12 2814

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 772 235 A (MITSUBISHI ELECTRIC CORP [JP]) 7 May 1997 (1997-05-07)<br>* figures 1-5,11,13 *<br>* column 9, line 35 - column 11, line 55 *<br>* column 12, line 41 - line 44 *<br>* column 15, line 21 - line 49 *<br>----- | 1-27 | INV.<br>H01L25/07<br>H01L25/18 |
| X | EP 0 828 341 A (HITACHI LTD [JP]; HITACHI KYOWA ENGINEERING CO L [JP]) 11 March 1998 (1998-03-11)<br><br>* figures 4-6,25,26 *<br>* column 1, line 51 - column 3, line 51 *<br>* column 6, line 33 - column 9, line 18 *<br>* column 16, line 27 - column 18, line 24 *<br>* column 26, line 11 - line 34 *<br>----- | 1-7,<br>11-16,<br>18-21,<br>23,25-27 | |
| X | EP 0 588 094 A (TOKYO SHIBAURA ELECTRIC CO [JP]) 23 March 1994 (1994-03-23)<br><br><br>* the whole document *<br>----- | 1-9,<br>11-14,<br>18-20,<br>22,23,<br>25-27 | **TECHNICAL FIELDS SEARCHED (IPC)**<br><br>H01L |
| X | EP 0 427 143 A (ABB IXYS SEMICONDUCTOR GMBH [DE] IXYS SEMICONDUCTOR GMBH [DE]) 15 May 1991 (1991-05-15)<br>* the whole document *<br>----- | 1-4,8,<br>11,12 | |
| X | DE 10 2006 006425 A1 (SEMIKRON ELEKTRONIK GMBH & CO [DE]) 23 August 2007 (2007-08-23)<br>* the whole document *<br>----- | 1-4,11,<br>12 | |

-/--

The present search report has been drawn up for all claims

| Place of search | Date of completion of the search | Examiner |
|---|---|---|
| The Hague | 16 April 2008 | Hofer, Christiane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 07 12 2814

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 87 00 978 U1 (SIEMENS AG, 1000 BERLIN UND 8000 MUENCHEN, DE) 5 March 1987 (1987-03-05) * the whole document * ----- | 1-4,8, 11,12 | |
| X | DE 92 03 000 U1 (EUPEC EUROPAEISCHE GESELLSCHAFT FUER LEISTUNGSHALBLEITER MBH + CO.KG,) 17 June 1992 (1992-06-17) * the whole document * ----- | 1-4,8, 11,12 | |
| X | DE 10 2006 004031 B3 (INFINEON TECHNOLOGIES AG [DE]) 8 March 2007 (2007-03-08) * the whole document * ----- | 1-4,11, 12 | |

TECHNICAL FIELDS SEARCHED (IPC)

The present search report has been drawn up for all claims

| Place of search | Date of completion of the search | Examiner |
|---|---|---|
| The Hague | 16 April 2008 | Hofer, Christiane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 12 2814

This annex lists the patent family members relating to the patent documents cited in the above-mentioned European search report.
The members are as contained in the European Patent Office EDP file on
The European Patent Office is in no way liable for these particulars which are merely given for the purpose of information.

16-04-2008

| Patent document cited in search report | | Publication date | Patent family member(s) | | Publication date |
|---|---|---|---|---|---|
| EP 0772235 | A | 07-05-1997 | DE | 69635440 D1 | 22-12-2005 |
| | | | DE | 69635440 T2 | 10-08-2006 |
| | | | JP | 3396566 B2 | 14-04-2003 |
| | | | JP | 9121019 A | 06-05-1997 |
| | | | US | 5751058 A | 12-05-1998 |
| EP 0828341 | A | 11-03-1998 | DE | 69726518 D1 | 15-01-2004 |
| | | | DE | 69726518 T2 | 07-10-2004 |
| EP 0588094 | A | 23-03-1994 | DE | 69323823 D1 | 15-04-1999 |
| | | | DE | 69323823 T2 | 05-08-1999 |
| | | | JP | 3053298 B2 | 19-06-2000 |
| | | | JP | 6069415 A | 11-03-1994 |
| | | | US | 5347158 A | 13-09-1994 |
| EP 0427143 | A | 15-05-1991 | DE | 3937045 A1 | 08-05-1991 |
| DE 102006006425 A1 | | 23-08-2007 | CN | 101064299 A | 31-10-2007 |
| | | | EP | 1843393 A2 | 10-10-2007 |
| | | | JP | 2007221126 A | 30-08-2007 |
| | | | KR | 20070081744 A | 17-08-2007 |
| | | | US | 2007194429 A1 | 23-08-2007 |
| DE 8700978 | U1 | 05-03-1987 | NONE | | |
| DE 9203000 | U1 | 17-06-1992 | NONE | | |
| DE 102006004031 B3 | | 08-03-2007 | US | 2007177358 A1 | 02-08-2007 |

EPO FORM P0459

For more details about this annex : see Official Journal of the European Patent Office, No. 12/82